# EUROPÄISCHE PATENTSCHRIFT

(11) **EP 2 882 885 B1**
(45) Veröffentlichungstag und Bekanntmachung des Hinweises auf die Patenterteilung: **25.05.2016**
(21) Anmeldenummer: 13791714.2
(22) Anmeldetag: 06.08.2013
(51) Int. Cl.: C23C 16/50, B30B 15/06, C23C 16/52, H01J 37/32

(54) **VERFAHREN ZUM PLASMABESCHICHTEN EINES PRESSBLECHS**
METHOD FOR THE PLASMA COATING OF A PRESS PLATEN
PROCÉDÉ POUR LE REVÊTEMENT AU PLASMA D'UNE TÔLE EMBOUTIE

(30) Priorität: 08.08.2012 AT 8772012
(43) Veröffentlichungstag der Anmeldung: 17.06.2015
(73) Patentinhaber: Berndorf Hueck Band und Preßblechtechnik GmbH, 2560 Berndorf (AT)
(72) Erfinder: GEBESHUBER, Andreas, A-4523 Neuzeug (AT); HEIM, Daniel, A-4600 Wels (AT); LAIMER, Johann, A-2500 Baden (AT); MÜLLER, Thomas, A-4623 Gunskirchen (AT); PROSCHEK, Michael, A-2525 Schönau (AT); STADLER, Otto, A-2560 Hernstein (AT); STÖRI, Herbert, A-2700 Wiener Neustadt (AT)
(74) Vertreter: Burger, Hannes
(86) Internationale Anmeldenummer: PCT/AT2013/050152
(87) Internationale Veröffentlichungsnummer: WO 2014/022872

(56) Entgegenhaltungen:
- EP-B1- 1 417 090
- DE-C1- 4 443 608
- JP-A- 2012 134 320
- US-A1- 2003 052 085
- US-A1- 2003 089 314
- US-A1- 2006 221 540
- US-A1- 2007 042 131

## Beschreibung

Die Erfindung betrifft eine Verwendung einer Vorrichtung zur Plasmabeschichtung eines Pressblechs, umfassend eine Vakuumkammer und eine darin angeordnete Elektrode, welche im Betrieb im Wesentlichen parallel zu dem genannten Pressblech und gegenüber dessen zu beschichtender Seite ausgerichtet ist. Weiterhin wird ein Verfahren zur Herstellung eines Pressblechs, angegeben. Schließlich betrifft die Erfindung auch ein Verfahren zur Herstellung ein- oder mehrschichtiger plattenförmiger Werkstoffe, insbesondere von Kunststoffen, Holzwerkstoffen und Laminaten mit und ohne Overlaypapieren.

Eine Vorrichtung und ein Verfahren der genannten Art sind prinzipiell bekannt. Beispielsweise offenbart die EP 1 417 090 B1 dazu ein Verfahren zur Bearbeitung und Herstellung einer Oberfläche eines Werkstoffes mit einem reproduzierbaren Glanzgrad sowie ein Presswerkzeug zur Anwendung des Verfahrens. Um die Standfestigkeit der Presswerkzeuge zu erhöhen, wird ein Presswerkzeug mit einer Beschichtung versehen, die aus Kohlenstoff mit diamantähnlichen Schichten besteht. Hierdurch wird der Abrieb der Presswerkzeugoberfläche bei der Bearbeitung von hoch abriebfesten Werkstoffen, beispielsweise bei der Herstellung von Fußbodenplatten mit Korundpartikeln in der Oberflächenschicht, erheblich reduziert.

Die genannten diamantartigen Schichten sind auch unter dem Begriff "Diamond like Carbon" (DLC) bekannt. Diese zeichnen sich durch hohe Härte und hohen Verschleißwiderstand aus und lassen sich beispielsweise mit Hilfe der plasmaunterstützten chemischen Gasphasenabscheidung (engl.: plasma enhanced chemical vapour deposition - PECVD) erzeugen. Dabei wird oberhalb des zu beschichtenden Werkstücks ein Plasma gezündet, aus welchem ionisierte Bestandteile auf das zu beschichtenden Werkstück gelangen.

Da die Tendenz zu immer größeren Formaten der eingangs genannten Werkstoffe (z.B. Fußbodenplatten, Spanplatten, Faserplatten usw.) geht, sind auch dementsprechend große Pressbleche für die Herstellung dieser Werkstoffe notwendig. Problematisch ist dabei, dass die auf das Pressblech aufgetragene Schicht nur sehr schwer in einem engen Toleranzbereich hergestellt werden kann und damit auch nur bedingt reproduzierbar ist. Ein Grund hierfür liegt in inhomogenen, respektive schwer beeinflussbaren Prozessbedingungen. Beispielsweise ist die Ionenkonzentration im Plasma über das Pressblech sehr unterschiedlich und schwer steuerbar, wodurch sich selbst bei über der Elektrode konstanter Feldstärke und Stromstärke unterschiedliche Ablagerungsgeschwindigkeiten aus dem Plasma ergeben. In der Realität können aber eine konstante respektive eine in einem engen Toleranzband verlaufende Feldverteilung und Stromverteilung ohnehin nicht erreicht werden, sodass auch dadurch unerwünschte Unterschiede in der Ablagerungsgeschwindigkeit der aufzubringenden Schicht resultieren. Unglücklicherweise führen die oben genannten Schwankungen noch dazu zu Instabilitäten im Prozess, sowie zu Schwingungsphänomenen. Beispielsweise führt eine lokal erhöhte Ionenkonzentration im Plasma wegen der erhöhten Leitfähigkeit zu einer lokal erhöhten Stromstärke, welche nicht nur eine erhöhte Ablagerungsgeschwindigkeit der aufzubringenden Schicht, sondern im Extremfall einen Überschlag verursachen können. Die Oberfläche des Pressbleches wird durch den hohen Strom dabei in aller Regel so stark zerstört, dass es entsorgt werden muss. Dies führt zu hohem wirtschaftlichen Schaden, da sowohl das Grundmaterial des Pressblechs, als auch die Bearbeitung desselben (beispielsweise das photolithografische Erzeugen einer Oberflächenstruktur oder das Erzeugen einer Oberflächenstruktur respektive einer Maske für Photolithografie mit Hilfe des Tintenstrahldruck-, Siebdruck-, Offsetdruck- oder Kalanderdruck-Verfahrens) sehr teuer ist. Je größer das Pressblech ist, umso größer wird auch die Wahrscheinlichkeit für das Auftreten eines der oben genannten Fehler.

Eine Aufgabe der Erfindung ist es daher, ein verbessertes Verfahren zur Plasmabeschichtung eines Pressblechs, anzugeben. Insbesondere soll eine Möglichkeit geschaffen werden, eine Schicht auf einem Pressblech in einem engen Toleranzbereich aufzutragen und einen elektrischen Überschlag im Plasma zu vermeiden, beziehungsweise dessen Auswirkungen abzumildern. Eine weitere Aufgabe der Erfindung besteht darin, ein verbessertes Herstellungsverfahren für ein- oder mehrschichtige plattenförmige Werkstoffe anzugeben. Insbesondere soll die Herstellung großformatiger Platten erleichtert beziehungsweise ermöglicht werden.

Die Aufgabe der Erfindung wird durch eine Verwendung nach Patentanspruch 1 gelöst. Besondere Ausführungsarten der erfindungsgemäßen Verwendung sind in Patentansprüchen 2-12 angegeben.

Weiterhin wird die Aufgabe der Erfindung durch ein Verfahren nach Patentanspruch 13 gelöst. Besondere Ausführungsarten des erfindungsgemäßen Verfahrens nach Patentanspruch 13 sind in den Patentansprüchen 14-20 angegeben.

Schließlich wird die Aufgabe der Erfindung durch ein Verfahren zur Herstellung ein- oder mehrschichtiger plattenförmiger Werkstoffe nach Patentanspruch 21 gelöst. Besondere Ausführungsarten des erfindungsgemäßen Verfahrens nach Patentanspruch 21 sind in Patentansprüchen 22-24 angegeben.

Ein Elektrodensegment ist im Rahmen der Erfindung dadurch definiert, dass es ein deutlich anderes Potential annehmen kann als die übrigen Segmente, ohne dass dabei ein nennenswerter Ausgleichsstrom fließen würde. Anders ausgedrückt ist zwischen den einzelnen Segmenten ein hoher Isolationswiderstand vorgesehen. Die Segmentierung ist im Sinne der Erfindung also in elektrischer Hinsicht, nicht unbedingt aber in baulicher Hinsicht zu sehen. Der Begriff "Anschluss" ist weit zu fassen, prinzipiell kann darunter eine Möglichkeit zum elektrischen Verbinden jedweder Bauart verstanden werden.

Erfindungsgemäß wird durch die Segmentierung erreicht, dass die Elektrode lokal unterschiedlich mit elektrischer Energie versorgt werden kann, beziehungsweise die Zufuhr elektrischer Energie sehr differenziert beeinflusst werden kann. Dadurch kann nicht nur eine Verteilung der elektrischen Feldstärke beziehungsweise der Stromstärke über das Pressblech vorgegeben werden, sondern die vorgegeben Werte können wegen der Segmentierung der Elektrode auch gut in einem engen Toleranzbereich gehalten werden. Beispielsweise kann die Energiezufuhr je Elektrodensegment eigenständig geregelt werden. Durch die Lücken zwischen den einzelnen Segmenten kann darüber hinaus auch das Prozessgas besser zum Pressblech geleitet werden, sodass die Ionenkonzentration über dem Pressblech konstant, beziehungsweise in einem engen Toleranzband gehalten werden kann.

Schließlich wird auch die Wahrscheinlichkeit für das Auftreten eines elektrischen Überschlags im Plasma deutlich reduziert, beziehungsweise werden die Auswirkungen desselben deutlich abgemildert. Durch die Segmentierung kann die elektrische Energie nämlich nicht aus anderen Bereichen der Elektrode "abgezogen" und auf einen Punkt konzentriert werden, so wie dies bei einer unsegmentierten Elektrode der Fall ist. Hier führt ein Überschlag zu einer Konzentration der für die Beschichtung des gesamten Pressblechs zur Verfügung gestellten Energie beziehungsweise Leistung auf einen Punkt und damit zu einer dementsprechend starken Schädigung des Pressblechs.

Werden jedoch Elektrodensegmente vorgesehen, so kann lediglich die für die Beschichtung des Pressblechs in diesem Bereich zur Verfügung gestellte elektrische Energie respektive Leistung auf einen Punkt konzentriert werden, welche naturgemäß kleiner ist als die für die Beschichtung des gesamten Pressblechs bereitgestellte elektrische Energie/Leistung. Je feiner die Segmentierung, umso kleiner sind die genannten Energiemengen beziehungsweise Leistungen. Durch entsprechend feine Segmentierung kann die Leistung pro Elektrodensegment bei gleichbleibender Leistung pro Fläche so stark reduziert werden, dass die elektrische Energie innerhalb des Segments für einen elektrischen Überschlag nicht mehr ausreicht. In jedem Fall können aber die Auswirkungen eines Überschlags abgemildert werden, da ja die Oberfläche des Pressblechs durch einen solchen nur mehr geringfügig beschädigt wird, sodass es ohne weiteres weiter verwendet oder mit nur geringem Aufwand repariert werden kann.

Generell ist es in den meisten Fällen das Ziel, ein Pressblech möglichst gleichmäßig zu beschichten. In diesem Fall können die oben genannten Maßnahmen dazu verwendet werden, um eine möglichst homogene Verteilung der Stromstärke, der elektrischen Feldstärke sowie der Ionenkonzentration im Plasma zu erreichen. Alternativ kann es aber auch das Ziel des Prozesses sein, das Pressblech inhomogen zu beschichten. In diesem Fall werden die genannten Maßnahmen dazu verwendet, eine inhomogene, jedoch in einem engen Toleranzband um eine vorgegebene Verteilung der Stromstärke, der elektrischen Feldstärke sowie der Ionenkonzentration im Plasma zu erreichen.

Durch die Bereitstellung der genannten Pressbleche wird auch die Herstellung von großformatigen Plattenwerkstoffen erleichtert beziehungsweise ermöglicht. Unter großformatigen

Platten sind im Rahmen der Erfindung Platten mit einer Größe von größer oder gleich 1 m², insbesondere Platten mit einer Größe von größer oder gleich 5 m² und im Speziellen Platten mit einer Größe von größer oder gleich 10 m² zu verstehen. Damit sind beispielsweise auch plattenförmige Werkstoffe mit einem Standardmaß von 2 x 5 m in einem Arbeitsgang herstellbar.

Vorteilhafte Ausgestaltungen und Weiterbildungen der Erfindung ergeben sich aus den Unteransprüchen sowie aus der Beschreibung in Zusammenschau mit den Figuren.

Vorteilhaft ist es, wenn die einzelnen Elektrodensegmente gegeneinander isoliert sind. Dadurch kann zwischen den Segmenten praktisch kein Ausgleichsstrom fließen.

Vorteilhaft ist es aber auch, wenn die einzelnen Elektrodensegmente über schmale Stege beziehungsweise definierte ohmsche Widerstände untereinander verbunden sind. Dadurch können geringe, definierte Ausgleichströme zwischen den Segmenten zugelassen werden, beziehungsweise kann die Elektrode trotz ihrer Segmentierung einstückig aufgebaut sein, wenn zwischen den Segmenten schmale Stege vorgesehen werden.

Vorteilhaft ist es zudem, wenn die einzelnen Elektrodensegmente über schmale Stege beziehungsweise definierte ohmsche Widerstände mit wenigstens einer Energiequelle verbunden sind. Vorteilhaft können die Elektrodensegmente auf diese Weise mit nur einer einzigen Energiequelle unterschiedlich mit Energie versorgt werden, indem unterschiedliche Widerstände zu den einzelnen Elektrodensegmenten vorgesehen werden. Zudem wird die Wahrscheinlichkeit für das Auftreten eines elektrischen Überschlags im Plasma deutlich reduziert, beziehungsweise werden die Auswirkungen desselben deutlich abgemildert, da die Widerstände eine Konzentration der elektrischen Energie in nur einem Elektrodensegment hemmen.

Besonders vorteilhaft ist es, wenn die Vorrichtung mehrere voneinander unabhängig steuerbare/regelbare Energiequellen umfasst, welche über die genannten Anschlüsse mit den Elektrodensegmenten verbunden sind. Auf diese Weise können mehrere Elektrodensegmente unabhängig voneinander mit Energie versorgt werden. Beispielsweise kann für diese eine eigene Stromstärke und/oder ein eigenes Potential vorgegeben, und wenn die Energiequelle geregelt ist, auch unter variierenden Prozessbedingungen eingehalten werden.

Besonders vorteilhaft ist es auch, wenn je ein Elektrodensegment mit je einer Energiequelle verbunden ist, welche unabhängig von den übrigen Energiequellen steuerbar/regelbar ist. Somit wird je eine Energiequelle pro Elektrodensegment aktiviert und unabhängig von den übrigen Energiequellen gesteuert/geregelt. Auf diese Weise können alle Elektrodensegmente unabhängig voneinander mit Energie versorgt werden. Beispielsweise kann für jedes Elektrodensegment eine eigene Stromstärke und/oder ein eigenes Potential vorgegeben, und wenn die Energiequelle geregelt ist, auch unter variierenden Prozessbedingungen eingehalten werden.

Besonders vorteilhaft ist es darüber hinaus, wenn die Vorrichtung eine Steuerung umfasst, welche dazu eingerichtet ist, eine Energiequelle abwechselnd auf je ein Elektrodensegment einer Gruppe von Elektrodensegmenten und die Anschlüsse der übrigen Elektrodensegmente dieser Gruppe in einen vom erstgenannten Elektrodensegment isolierten Offen-Zustand zu schalten. Somit wird eine Energiequelle abwechselnd auf je ein Elektrodensegment einer Gruppe von Elektrodensegmenten geschaltet, und die Anschlüsse der übrigen Elektrodensegmente dieser Gruppe werden in einen vom erstgenannten Elektrodensegment isolierten Offen-Zustand geschaltet. Dadurch ist es möglich, alle Elektrodensegmente mit einer nur geringen Anzahl von Energiequellen unabhängig voneinander mit Energie zu versorgen. Dabei wird jeweils ein Elektrodensegment einer Gruppe von Elektrodensegmenten mit der Energiequelle verbunden und für diese eine Stromstärke und/oder ein Potential vorgegeben. Die übrigen Elektrodensegmente dieser Gruppe werden in einen Offen-Zustand geschaltet, in dem sie von der Energiequelle beziehungsweise dem mit diesem verbunden Elektrodensegment isoliert sind. Die Stromstärke für diese Elektrodensegmente beträgt somit Null, oder es kann nur ein geringer Ausgleichsstrom zwischen den Segmenten fließen. Dementsprechend kann das Potential praktisch jeden beliebigen Wert annehmen ("floating potential"). Nach einer gewissen Zeit wird die Energiequelle mit einem anderen Elektrodensegment der Gruppe verbunden und das zuvor verbundene Elektrodensegment ebenfalls in einen Offen-Zustand geschaltet. Auf diese Weise können alle Elektrodensegmente der Gruppe nach und nach mit der Energiequelle verbunden werden. Dafür ist keinesfalls nötig, dass die Elektrodensegmente in jedem Zyklus in derselben Reihenfolge mit der Energiequelle verbunden werden. Auch kann ein Elektrodensegment in einem Zyklus mehrmals mit der Energiequelle verbunden werden, um dort beispielsweise eine dickere Beschichtung auf das Pressblech aufzubringen.

Beispielsweise kann die Auswahl des Elektrodensegments, welcher der aktivierten Energiequelle zugeordnet ist, auch zufällig erfolgen. Damit können Effekte vermieden, die durch die immer selbe Wiederholung ein und desselben Zyklus entstehen können.

Besonders vorteilhaft ist es auch, wenn nach Art der weißen Felder eines Schachbretts angeordnete Elektrodensegmente und nach Art der schwarzen Felder eines Schachbretts angeordnete Elektrodensegmente abwechselnd mit elektrischer Energie versorgt werden. Bei dieser Variante werden also in einer Matrix angeordnete Elektrodensegmente abwechselnd aktiviert. In einem ersten Zeitabschnitt werden dabei jene Segmente aktiviert, deren Zeilen- und Spaltenindex in Summe eine gerade Zahl ergibt. In einem zweiten Zeitabschnitt werden dann jene Segmente aktiviert, deren Zeilen- und Spaltenindex in Summe eine ungerade Zahl ergibt. Danach folgt wieder ein erster Zeitabschnitt usw.

Günstig ist es, wenn die Fläche eines Elektrodensegments kleiner gleich 1 m² ist. Noch günstiger ist es, wenn die genannte Fläche kleiner gleich 0,25 m² ist. Diese Werte stellen einen guten Kompromiss dar, bei dem die Beschichtung des Pressblechs bei nicht allzu starker Segmentierung der Elektrode gut gelingt. Obwohl sich die genannten Werte als vorteilhaft herausgestellt haben, ist die Erfindung natürlich nicht auf dieselben limitiert. Selbstverständlich können auch andere Werte im Rahmen der mit der Erfindung erzielten Vorteile gewählt werden.

Günstig ist es, wenn die Energiequellen als Stromquellen ausgebildet sind. Auf diese Weise ist es möglich, die Ablagerungsgeschwindigkeit der auf das Pressblech aufzubringenden Beschichtung einzustellen.

Vorteilhaft ist es in diesem Zusammenhang, wenn die die maximale Stromstärke je Elektrodensegment (Spitzenstrom) kleiner gleich 150 A ist. Noch vorteilhafter ist es, wenn die genannte Stromstärke kleiner gleich 15 A ist. Diese Werte stellen einen guten Kompromiss dar, bei dem die Beschichtung des Pressblechs bei nicht allzu hohem Risiko eines zerstörerischen elektrischen Überschlags zwischen Elektrode und Pressblech gut gelingt. Obwohl sich die genannten Werte als vorteilhaft herausgestellt haben, ist die Erfindung natürlich nicht auf dieselben limitiert. Selbstverständlich können auch andere Werte im Rahmen der mit der Erfindung erzielten Vorteile gewählt werden.

Vorteilhaft ist es auch, wenn die Elektrodensegmente gitterförmig ausgebildet sind. Dadurch kann das Prozessgas besonders gut zum beschichtenden Pressblech geleitet werden.

Vorteilhaft ist es zudem, wenn die Elektrode in ihrem Randbereich in Richtung des zu beschichtenden Pressblechs gebogen ist. Auf diese Weise kann ein Abfall der elektrischen Feldstärke im Plasma im Randbereich der Elektrode, so wie er sich bei einer plattenförmigen Elektrode ergibt, welche überall denselben Abstand zum Pressblech aufweist, ausgeglichen werden.

Eine vorteilhafte Variante eines Verfahrens zum Beschichten eines Pressblechs ist auch gegeben, wenn die Spannung zwischen einem Elektrodensegment und dem zu beschichtenden Pressblech gemessen wird und die Energieversorgung abgeregelt oder abgeschaltet wird, wenn ein Einbruch der genannten Spannung festgestellt wird. Sinkt die genannte Spannung sehr rasch auf einen relativ geringen Wert, so kann davon ausgegangen werden, dass zwischen Werkstück und Elektrode ein elektrischer Überschlag erfolgt. Um die schädlichen Auswirkungen desselben einzudämmen, beziehungsweise auch um diese zu beenden, wird die Energieversorgung des betroffenen Elektrodensegments abgeregelt oder sogar abgeschaltet.

Vorteilhaft ist es, wenn am Rand der Elektrode gelegene Elektrodensegmente auf ein höheres Potential gelegt werden, als innenliegende Segmente. Auf diese Weise kann ein Abfall der elektrischen Feldstärke im Plasma, so wie er sich bei einer parallel zum Pressblech ausgerichteten, plattenförmigen Elektrode ergibt, ausgeglichen werden.

Vorteilhaft ist es auch, wenn am Rand der Elektrode gelegene Elektrodensegmente auf eine höhere Stromstärke eingestellt oder geregelt werden als innenliegende Segmente. Auf diese Weise kann das Pressblech an dessen Rand mit einer dickeren Schicht versehen werden. Üblicherweise werden die Pressbleche bei der Herstellung plattenförmiger Werkstoffe dort nämlich am höchsten beansprucht.

Vorteilhaft ist es schließlich, wenn der plattenförmige Werkstoff Partikel mit einer Vickershärte zwischen 1000 und 1800 oder Korund respektive Aluminiumoxid Al₂O₃ beinhaltet, insbesondere im Bereich seiner dem Pressblech zugewandten Oberfläche. Der Vorteil des beschichteten Pressblechs tritt an dieser Stelle besonders hervor, da durch die Beschichtung trotz abrasiver Bestandteile in dem herzustellenden Werkstoff eine hohe Standzeit des Pressblechs gewährleistet werden kann. Pressbleche für großformatige plattenförmige Werkstoffe nach dem Stand der Technik können eine so lange Standzeit nicht aufweisen.

An dieser Stelle wird angemerkt, dass die zur Beschichtungsvorrichtung angeführten Varianten und die sich daraus ergebenden Vorteile sinngemäß auch auf das Verfahren zum Beschichten des Pressblechs anwendbar sind und umgekehrt.

Zum besseren Verständnis der Erfindung wird diese anhand der nachfolgenden Figuren näher erläutert.
- Fig. 1: schematisch eine Vorrichtung zur Plasmabeschichtung eines Substrats;
- Fig. 2: ein erstes schematisch dargestelltes Beispiel einer Elektrode mit vollständig voneinander isolierten Segmenten;
- Fig. 3: ein zweites schematisch dargestelltes Beispiel einer Elektrode mit untereinander verbundenen Segmenten;
- Fig. 4: ein weiteres schematisch dargestelltes Beispiel einer gitterförmigen Elektrode;
- Fig. 5: ein weiteres schematisch dargestelltes Beispiel einer Elektrode mit unterschiedlich geformten Segmenten;
- Fig. 6: ein weiteres schematisch dargestelltes Beispiel einer im Randbereich gebogenen Elektrode;
- Fig. 7: ein illustratives Beispiel, bei dem eine Steuerung eine Energiequelle auf verschiedene Elektrodensegmente schaltet;
- Fig. 8: ein Beispiel einer Elektrode, deren Segmente nach Art eines Schachbretts angeordnet beziehungsweise angesteuert werden;
- Fig. 9: ein illustratives Beispiel, bei dem je ein Elektrodensegment mit je einer Energiequelle verbunden ist;
- Fig. 10: ein weiteres illustratives Beispiel, bei dem eine Spannung zwischen einem Elektrodensegment und dem Substrat gemessen wird;
- Fig. 11: ein schematisch dargestelltes Beispiel, bei dem am Rand der Elektrode gelegene Segmente auf ein höheres Potential gelegt und/oder auf eine höhere Stromstärke eingestellt/geregelt werden, als innenliegende Segmente und
- Fig. 12: ein schematisch dargestelltes Beispiel, bei dem die Elektrodensegmente über Widerstände mit einer Energieversorgung verbunden sind.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

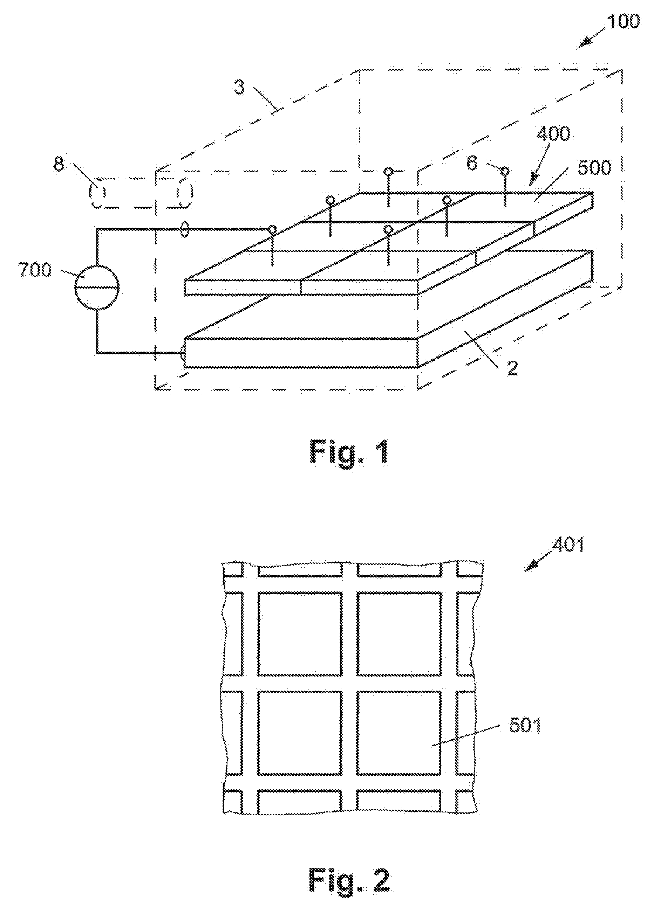

Fig. 1 zeigt eine Vorrichtung 100 zur Plasmabeschichtung eines Substrats 2, umfassend eine Vakuumkammer 3 und eine darin angeordnete Elektrode 400, welche im Betrieb im Wesentlichen parallel zu dem genannten Substrat 2 und gegenüber dessen zu beschichtender Seite ausgerichtet ist. Für die folgenden Betrachtungen wird angenommen, dass es sich bei dem Substrat um ein Pressblech 2 handelt. Selbstverständlich kann die nachfolgende Lehre aber auch auf andere Substrate angewendet werden.

Die Elektrode 400 ist segmentiert, und jedes der Segmente 500 weist einen eigenen Anschluss 6 für eine elektrische Energiequelle 700 auf, welche in diesem Beispiel als Stromquelle ausgeführt ist. Selbstverständlich könnte die Energiequelle aber auch beispielsweise als Spannungsquelle ausgeführt sein. Schließlich zeigt Fig. 1 noch einen Anschluss 8 zur Einleitung eines Prozessgases (z.B. CH₄) in die Vakuumkammer 3, in der beispielsweise ein Druck von etwa 1 mbar herrscht.

Vorzugsweise ist die Fläche eines Elektrodensegments 500 kleiner gleich 1 m², und die die Stromstärke einer Stromquelle 700 ist kleiner gleich 150 A ist. Diese Werte stellen einen guten Kompromiss dar, bei dem die Beschichtung des Pressbleches 2 bei nicht allzu starker Segmentierung der Elektrode 400 gut gelingt und das Risiko eines zerstörerischen elektrischen Überschlags zwischen Elektrode 400 und Pressblech 2 nicht allzu hoch ist.

Generell kann die Energiequelle 700 Gleichstrom oder Wechselstrom liefern. Besonders gut gelingt die Beschichtung des Pressblechs 2 mit impulsförmigem Strom. In diesem Fall ist die Stromamplitude der Impulse vorzugsweise kleiner als 150 A. Um elektrische Ladungen an der aufgebrachten Schicht abzuführen, z.B. wenn elektrisch isolierende Schichten aufgebracht werden, kann die Polarität der Pulse von Zeit zu Zeit auch umgekehrt werden. Beispielsweise kann einer von zehn Pulsen eine andere Polarität aufweisen.

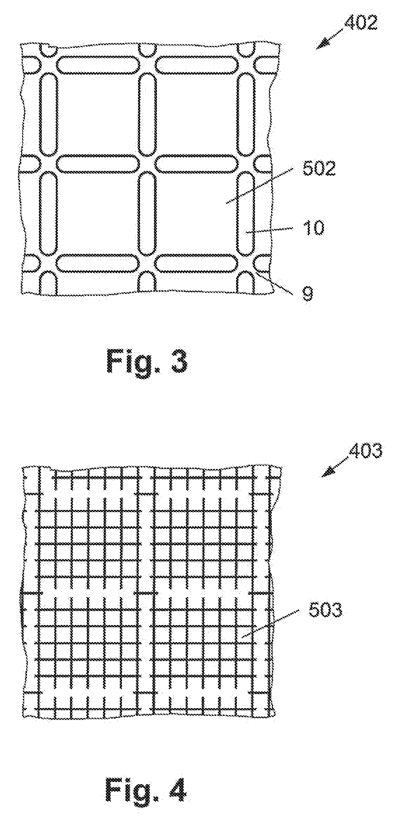

Fig. 2 zeigt nun ein Beispiel einer Elektrode 401, deren Segmente 501 vollständig voneinander isoliert sind. Die einzelnen Segmente 501 sind also durch einzelne leitfähige und voneinander beabstandete Platten gebildet. Diese können beispielsweise auf einem nicht leitenden Substrat aufgebtracht werden, sodass die Elektrode 401 leichter handhabbar ist. Die Elektrode 401 kann auch gelocht sein, damit das Prozessgas leichter zum Pressblech 2 gelangen kann, insbesondere durch Ausnehmungen in dem genannten Substrat im Bereich zwischen den Segmenten 501. Beispielsweise können diese die Form von Langlöchern haben (siehe dazu auch Fig. 3).

Fig. 3 zeigt ein weiteres Beispiel einer Elektrode 402, deren Segmente 502 über schmale Stege 9 und somit über (hohe) ohmsche Widerstände untereinander verbunden sind. Die Elektrode 402 kann somit prinzipiell einstückig ausgeführt werden, indem aus einem Blech entsprechende Ausnehmungen 10 beispielsweise ausgefräst, ausgestanzt, ausgenibbelt oder mit einem Laser ausgeschnitten werden.

Fig. 4 zeigt ein weiteres Beispiel einer Elektrode 403, bei dem die Elektrodensegmente 503 gitterförmig ausgebildet sind. Auf diese Weise kann das Prozessgas noch leichter zum Pressblech 2 gelangen.

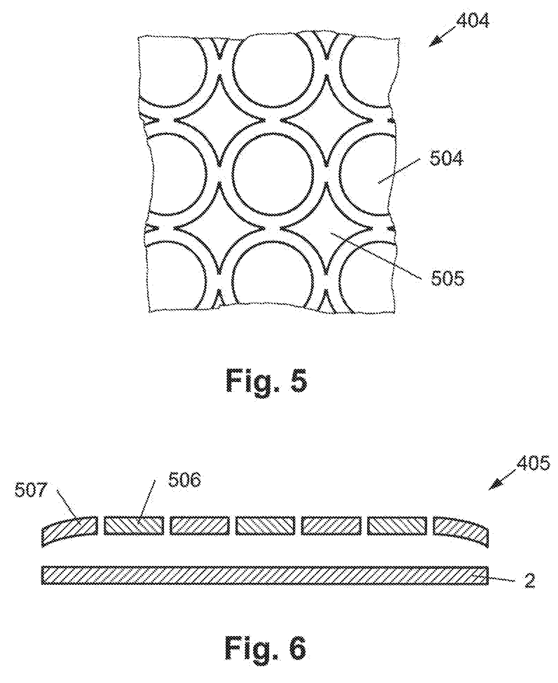

Fig. 5 zeigt ein weiteres Beispiel einer Elektrode 404, welches aus kreisrunden Elektrodensegmenten 504 und Karo-förmigen Elektrodensegmenten 505 aufgebaut ist. Dieses Beispiel ist rein illustrativ und soll lediglich demonstrieren, dass eine Elektrode 400 nicht notwendigerweise aus rechteckförmigen Elektrodensegmenten 500 aufgebaut ist. Neben den in der Fig. 5 dargestellten Formen ist natürlich eine Vielzahl anderer nicht-rechteckförmiger Formen einsetzbar.

Fig. 6 zeigt nun ein Beispiel einer Elektrode 405, welche in ihrem Randbereich in Richtung des zu beschichtenden Pressblechs 2 gebogen ist. Konkret sind die Elektrodensegmente 506 parallel zum Pressblech 2 angeordnet, die Elektrodensegmente 507 dagegen in Richtung des Pressblechs 2 geneigt oder wie in diesem Beispiel in Richtung des Pressblechs 2 gebogen. Auf diese Weise kann ein Abfall der elektrischen Feldstärke im Plasma, so wie er sich bei einer auch im Randbereich des Pressblechs 2 parallel zu demselben ausgerichteten, plattenförmigen Elektrode ergibt, ausgeglichen werden.

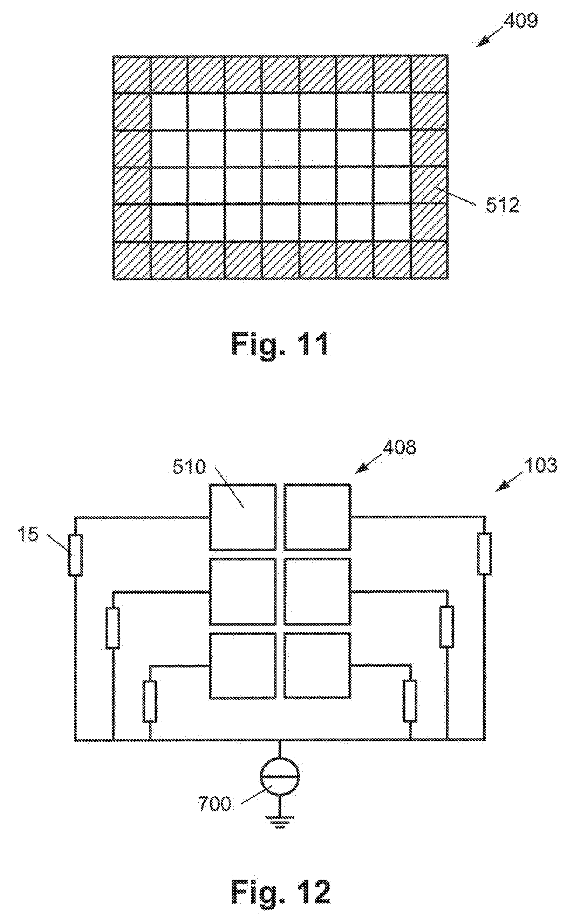

Alternativ oder zusätzlich zu der in Fig. 6 dargestellten Ausführungsform wäre beispielsweise auch vorstellbar, dass im Randbereich der Elektrode 400 gelegene Segmente 500 (vergleiche hierzu auch Fig. 11) näher am Pressblech 2 angeordnet sind als innenliegende Segmente. Insbesondere können alle Segmente 500 parallel zum Pressblech 2 angeordnet sein.

Bei einem Verfahren zur Herstellung eines Pressblechs 2 werden nun folgende Schritte ausgeführt:
a) Anordnen eines zu beschichtenden Pressblechs 2 in einer Vakuumkammer 3 gegenüber einer in der Vakuumkammer 3 angeordneten, segmentierten Elektrode 400 und im Wesentlichen parallel ausgerichtet zu derselben,
b) Aktivierung wenigstens einer, einem Elektrodensegment 500 zugeordneten Energiequelle 700 und
c) Einleiten eines Gases, welches eine plasmaunterstützte chemische Gasphasenabscheidung auf dem Pressblech-Rohling 2 bewirkt.
Der Vollständigkeit halber wird an dieser Stelle angemerkt, dass Schritt c) natürlich auch vor Schritt b) ausgeführt werden kann.

In der Fig. 1 ist rein illustrativ nur eine einzige Energiequelle 700 dargestellt, welche mit einem Elektrodensegment 500 verbunden ist. Diese kann prinzipiell nacheinander mit den verschiedenen Elektrodensegmenten 500 verbunden werden. Alternativ ist aber auch vorstellbar, dass eine Vorrichtung zur Plasmabeschichtung eines Pressblechs 2 mehrere voneinander unabhängig steuerbare/regelbare Energiequellen 700 umfasst, welche über die Anschlüsse 6 mit den Elektrodensegmenten 500 verbindbar oder verbunden sind.

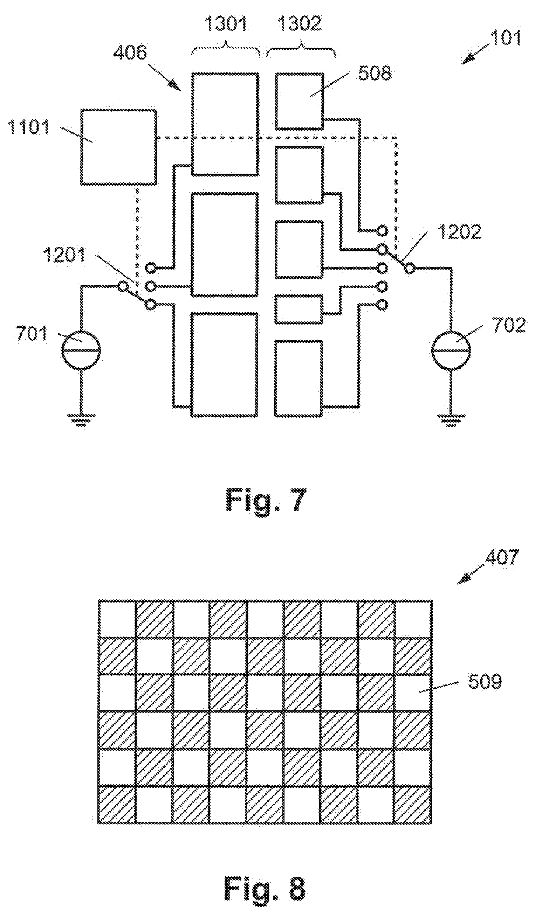

Fig. 7 zeigt dazu ein illustratives Beispiel, bei dem eine Steuerung 1101 einer Vorrichtung 101 (hier ohne Vakuumkammer 3 dargestellt) dazu eingerichtet ist, eine Energiequelle 701, 702 mit Hilfe der Schalter 1201 und 1202 abwechselnd auf je ein Elektrodensegment 508 einer Gruppe 1301, 1302 von Elektrodensegmenten 508 zu schalten, und die Anschlüsse der übrigen Elektrodensegmente 508 dieser Gruppe 1301, 1302 in einen vom erstgenannten Elektrodensegment 508 isolierten Offen-Zustand zu schalten (das Pressblech 2 liegt in diesem Beispiel und den weiteren Beispielen auf Masse). Konkret sind die Elektrodensegmente 508 in dem in Fig. 7 dargestellten Beispiel in zwei Gruppen 1301 und 1302 unterteilt, wobei die erste Gruppe 1301 drei gleich große Elektrodensegmente 508 und die zweite Gruppe 1302 fünf unterschiedlich große Elektrodensegmente 508 umfasst. Die Unterteilung ist rein illustrativ und soll unter anderem demonstrieren, dass die Elektrodensegmente 508 einer Elektrode 406 nicht notwendigerweise gleich groß sein müssen. Weiterhin ist der Fig. 7 auch zu entnehmen, dass die Elektrodensegmente 508 nicht notwendigerweise quadratisch sein müssen, sondern auch allgemein rechteckförmig sein können. Insbesondere können die Elektrodensegmente 508 in Form von Bändern, Stäben und/oder Streifen ausgeführt sein. Eine erste Energiequelle 701 wird nun auf je ein Elektrodensegment 508 der Gruppe 1301, eine zweite Energiequelle 702 auf ein Elektrodensegment 508 der Gruppe 1302 geschaltet. Die übrigen Elektrodensegmente 508 werden in einen Offen-Zustand geschaltet.

Nach einer gewissen Zeit werden die Zuordnungen zwischen den Energiequellen 701, 702 und den Elektrodensegmenten 508 geändert. Das heißt, dass die Energiequelle 701 mit einem anderen Elektrodensegment 508 der Gruppe 1301 verbunden und das zuvor verbundene Elektrodensegment 508 in einen Offen-Zustand geschaltet wird. Analog dazu wird die Energiequelle 702 mit einem anderen Elektrodensegment 508 der Gruppe 1302 verbunden, und das zuvor verbundene Elektrodensegment 508 wird in einen Offen-Zustand geschaltet. Auf diese Weise können alle Elektrodensegmente 508 der Gruppen 1301 und 1302 nach und nach mit den Energiequellen 701 und 702 verbunden werden. Dadurch ist es möglich, alle Elektrodensegmente 508 mit einer nur geringen Anzahl von Energiequellen 701, 702 unabhängig voneinander mit Energie zu versorgen.

Die Auswahl des Elektrodensegments 508, welcher der aktivierten Energiequelle 701, 702 zugeordnet ist, kann zufällig oder nach einem vorgegebenen Schema erfolgen. Die Elektrodensegmente 508 müssen dabei nicht in jedem Zyklus in derselben Reihenfolge mit der Energiequelle 701, 702 verbunden werden. Auch kann ein Elektrodensegment 508 in einem Zyklus mehrmals mit der Energiequelle 701, 702 verbunden werden.

Ein besonders vorteilhaftes Verfahren ist gegeben, wenn nach Art der weißen Felder eines Schachbretts angeordnete Elektrodensegmente und nach Art der schwarzen Felder eines Schachbretts angeordnete Elektrodensegmente abwechselnd mit elektrischer Energie versorgt werden. Fig. 8 zeigt dazu ein illustratives Beispiel mit Elektrodensegmenten 509, die in einer 6x9 Matrix angeordnet sind, um zu verdeutlichen, dass die Elektrodensegmente 509 nicht unbedingt in einer 8x8 Matrix angeordnet sein müssen, so wie dies bei einem Schachbrett der Fall ist. Entsprechend dieser Variante werden in einem ersten Zeitabschnitt die "weißen" Segmente 509, in einem zweiten Abschnitt die "schwarzen" Segmente 509 (hier schraffiert dargestellt) aktiviert.

Bei der Zuordnung einer Energiequelle 701, 702 zu einem Elektrodensegment 508 kann generell eine Stromstärke und/oder ein Potential für dasselbe vorgegeben werden. Die übrigen Elektrodensegmente 508, welche keiner Energiequelle 701, 702 zugeordnet sind, werden in einen Offen-Zustand geschaltet, in dem sie von der Energiequelle 701, 702 beziehungsweise dem mit diesem verbunden Elektrodensegment 508 isoliert sind. Die Stromstärke für diese Elektrodensegmente 508 beträgt somit Null, oder es kann nur ein geringer Ausgleichsstrom zwischen den Segmenten 508 fließen. Dementsprechend kann das Potential praktisch jeden beliebigen Wert annehmen ("floating potential").

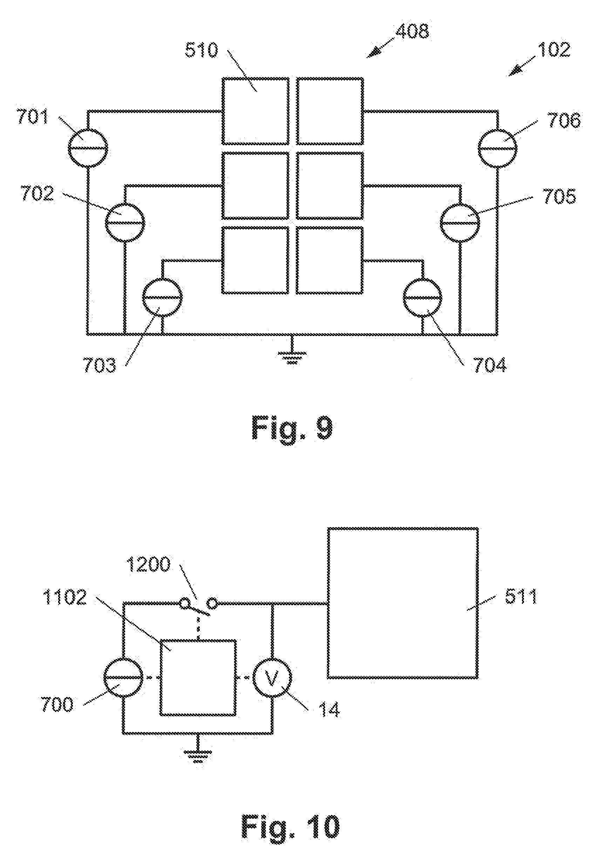

Fig. 9 zeigt nun ein Beispiel, bei dem je ein Elektrodensegment 510 mit je einer Energiequelle 701..706 verbunden ist, welche unabhängig von den übrigen Energiequellen 701..706 steuerbar/regelbar ist. Das heißt die Energiequelle 701 ist unabhängig von den Energiequellen 702..706 steuerbar/regelbar usw. Dementsprechend wird je eine Energiequelle 701..706 pro Elektrodensegment 510 aktiviert und unabhängig von den übrigen Energiequellen 701..706 gesteuert/geregelt. Auf diese Weise können alle Elektrodensegmente 510 unabhängig voneinander mit Energie versorgt werden. Beispielsweise kann für jedes Elektrodensegment 510 eine eigene Stromstärke und/oder ein eigenes Potential vorgegeben, und wenn die Energiequelle 701..706 geregelt ist, auch unter variierenden Prozessbedingungen eingehalten werden.

In einem weiteren in Fig. 10 dargestellten Beispiel wird die Spannung zwischen einem Elektrodensegment 511 und dem zu beschichtenden Pressblech 2 mit Hilfe eines Spannungsmessgerätes 14 gemessen und die Energieversorgung 700 durch eine Steuerung 1102 abgeregelt und/oder die Stromzufuhr zum Elektrodensegment 511 mit Hilfe eines von der Steuerung 1102 betätigen Schalters 1200 abgeschaltet, wenn ein Einbruch der genannten Spannung festgestellt wird. Das Spannungsmessgerät 14 kann beispielsweise als Analog-Digital-Konverter ausgebildet sein, welcher an einen Mikrokontroller angeschlossen ist, in dem beispielsweise auch die Steuerung 1102 integriert sein kann. Auf diese Weise kann ein elektrischer Überschlag zwischen dem Elektrodensegment 511 und dem Pressblech festgestellt, sowie dessen zerstörerische Wirkung eingedämmt werden. Darüber hinaus ist es auch möglich, den Überschlag durch die oben genannten Maßnahmen aktiv zu beenden. Selbstverständlich kann auch eine gemeinsame Steuerung für die Funktionalität der in der Fig. 7 dargestellten Steuerung 1101 und der in der Fig. 10 dargestellten Steuerung 1102 vorgesehen sein.

In einer weiteren Variante des Verfahrens zur Plasmabeschichtung eines Pressblechs 2 werden in Fig. 11 am Rand einer Elektrode 409 gelegene Segmente 512 (schraffiert dargestellt) auf ein höheres Potential gelegt und/oder auf eine höhere Stromstärke eingestellt/geregelt als innenliegende Segmente 512 (weiß dargestellt). Auf diese Weise kann ein Abfall der elektrischen Feldstärke im Plasma, so wie er sich bei einer parallel zum Pressblech 2 ausgerichteten, plattenförmigen Elektrode 409 ergibt (vergleiche dazu auch Fig. 6), ausgeglichen werden und/oder das Pressblech 2 kann an dessen Rand mit einer dickeren Schicht versehen werden. Üblicherweise werden die Pressbleche 2 bei der Herstellung plattenförmiger Werkstoffe dort nämlich am höchsten beansprucht.

Fig. 12 zeigt schließlich ein schematisch dargestelltes Beispiel, bei dem die Elektrodensegmente 510 über Widerstände 15 mit einer Energiequelle 700 verbunden sind. Vorteilhaft können die Elektrodensegmente 510 auf diese Weise mit nur einer einzigen Energiequelle 700 unterschiedlich mit Energie versorgt werden, indem unterschiedliche Widerstände 15 vorgesehen werden. Selbstverständlich können aber auch gleiche Widerstände 15 vorgesehen sein. Zudem wird die Wahrscheinlichkeit für das Auftreten eines elektrischen Überschlags im Plasma deutlich reduziert, beziehungsweise werden die Auswirkungen desselben deutlich abgemildert, da die Widerstände 15 eine Konzentration der elektrischen Energie in nur einem Elektrodensegment 510 hemmen. Selbstverständlich kann die in Fig. 12 dargestellte Anordnung 103 auch in Kombination mit den bereits dargestellten Anordnungen angewendet werden. Beispielsweise können anstelle einer einzelnen Energiequelle 700 auch mehrere Energiequellen vorgesehen sein. Darüber hinaus ist beispielsweise auch vorstellbar, dass zwischen den Elektrodensegmenten 510 weitere nicht dargestellte Widerstände angeordnet sind, etwa weil die Elektrode 408 so wie in den Figuren 3 und 4 ausgeführt ist. Schließlich ist auch vorstellbar, dass die Widerstände 15 durch schmale Anschlussfahnen 6 gebildet sind, insbesondere wenn vergleichsweise hohe Ströme zu den Elektrodensegment 510 geleitet werden müssen.

Die Ausführungsbeispiele zeigen mögliche Ausführungsvarianten einer erfindungsgemäßen Vorrichtung 100..103 zur Plasmabeschichtung eines Pressblechs 2, wobei an dieser Stelle bemerkt sei, dass die Erfindung nicht auf die speziell dargestellten Ausführungsvarianten desselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.

Insbesondere wird festgehalten, dass die genannte Vorrichtung 100..103 in der Realität auch mehr Bestandteile als dargestellt umfassen kann. Insbesondere wird auch darauf hingewiesen, dass die offenbarte Lehre zwar besonders vorteilhaft im Zusammenhang mit Pressblechen ist, jedoch uneingeschränkt auch auf andere Substrate wie zum Beispiel für Tiefzieh-, Extrusionsund allgemein Presswerkzeuge angewandt werden kann.

Im Speziellen eignen sich die vorgestellten Pressbleche 2 zur Herstellung ein- oder mehrschichtiger plattenförmiger Werkstoffe. Insbesondere sind darunter Thermoplaste und Duroplaste wie zum Beispiel Epoxydharze, Polyesterharze und Phenolharze zu verstehen, welche für eine erhöhte Abriebfestigkeit wenigstens an deren dem Pressblech 2 zugewandten Oberfläche mit Partikeln mit einer Vickershärte zwischen 1000 und 1800 oder auch Korundpartikeln (Al₂O₃) versetzt sein können. In gleicher Weise sind Holzfaserwerkstoffe wie zum Beispiel Spanplatten, Mitteldichte Faserplatten (MDF) und Hochdichte Faserplatten (HDF) herstellbar. Insbesondere können diese Holzwerkstoffe zur Herstellung eines Laminats mit Schichten aus Kunststoff der genannten Art beziehungsweise auch Papier beschichtet werden. Weiterhin können auch glasfaserverstärkte oder kohlenfaserverstärkte Kunststoffe leicht mit einer Oberflächenstruktur versehen werden. Schließlich ist beispielsweise auch die Herstellung von Kunststein beziehungsweise "Engineered Stone" (Verbundmaterial aus Stein und Harz) möglich. Insbesondere bei Verwendung von hartem Gestein wie zum Beispiel Granit erweist sich die hohe Standzeit der offenbarten Substrate 2 beziehungsweise Pressbleche als vorteilhaft.

Der Ordnung halber sei abschließend darauf hingewiesen, dass zum besseren Verständnis des Aufbaus der Vorrichtung 100..103 zur Plasmabeschichtung eines Substrats 2 diese bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

### Bezugszeichenaufstellung

- 100..103: Vorrichtung zur Plasmabeschichtung
- 2: Substrat (Pressblech)
- 3: Vakuumkammer
- 400..409: Elektrode
- 500..512: Elektrodensegment

- 6: Elektrodenanschluss
- 700..702: Energiequelle
- 8: Gasanschluss
- 9: Steg
- 10: Ausnehmung

- 1101, 1102: Steuerung
- 1201, 1202: Schalter
- 1301, 1302: Gruppe von Elektrodensegmenten
- 14: Spannungsmessgerät
- 15: (ohmscher) Widerstand

## Patentansprüche

1. Verwendung einer Vorrichtung (100..103) zur Plasmabeschichtung eines Pressblechs (2), wobei die Vorrichtung eine Vakuumkammer (3) und eine darin angeordnete Elektrode (400..409) umfasst, welche im Betrieb im Wesentlichen parallel zu dem genannten Pressblech (2) und gegenüber dessen zu beschichtender Seite ausgerichtet ist, wobei die Elektrode (400..409) segmentiert ist und jedes der Elektrodensegmente (500..512) einen eigenen Anschluss (6) für eine elektrische Energiequelle (700..702) aufweist.

2. Verwendung nach Anspruch 1, **dadurch gekennzeichnet, dass** die einzelnen Elektrodensegmente (501, 504, 505) der Vorrichtung (100..103) gegeneinander isoliert sind.

3. Verwendung nach Anspruch 1, **dadurch gekennzeichnet, dass** die einzelnen Elektrodensegmente (502, 503) der Vorrichtung (100..103) über schmale Stege (9) beziehungsweise definierte ohmsche Widerstände untereinander verbunden sind.

4. Verwendung nach einem der Ansprüche 1 bis 3, **dadurch gekennzeichnet, dass** die einzelnen Elektrodensegmente (510) der Vorrichtung (100..103) über schmale Stege beziehungsweise definierte ohmsche Widerstände mit wenigstens einer Energiequelle (700) verbunden sind.

5. Verwendung nach einem der Ansprüche 1 bis 4, **dadurch gekennzeichnet, dass** die Vorrichtung (100..103) mehrere voneinander unabhängig steuerbare/regelbare Energiequellen (701, 702) umfasst, welche über die genannten Anschlüsse (6) mit den Elektrodensegmenten (500..512) verbunden sind.

6. Verwendung nach Anspruch 5, **dadurch gekennzeichnet, dass** je ein Elektrodensegment (510) der Vorrichtung (100..103) mit je einer Energiequelle (701..706) verbunden ist, welche unabhängig von den übrigen Energiequellen (701..706) steuerbar/regelbar ist.

7. Verwendung nach Anspruch 5, **dadurch gekennzeichnet, dass** die Vorrichtung (100..103) eine Steuerung (1101) umfasst, welche dazu eingerichtet ist, eine Energiequelle (701, 702) abwechselnd auf je ein Elektrodensegment (508) einer Gruppe (1301, 1302) von Elektrodensegmenten (508) und die Anschlüsse (6) der übrigen Elektrodensegmente (508) dieser Gruppe (1301, 1302) in einen vom erstgenannten Elektrodensegment (508) isolierten Offen-Zustand zu schalten.

8. Verwendung nach einem der vorgehenden Ansprüche, **dadurch gekennzeichnet, dass** die Fläche eines Elektrodensegments (500..512) der Vorrichtung (100..103) kleiner gleich 1 m² ist.

9. Verwendung nach einem der vorgehenden Ansprüche, **dadurch gekennzeichnet, dass** die Energiequellen (700..706) der Vorrichtung (100..103) als Stromquellen ausgebildet sind.

10. Verwendung nach Anspruch 9, **dadurch gekennzeichnet, dass** die die maximale Stromstärke je Elektrodensegment (500..512) kleiner gleich 150 A ist.

11. Verwendung nach einem der vorgehenden Ansprüche, **dadurch gekennzeichnet, dass** die Elektrodensegmente (503) der Vorrichtung (100..103) gitterförmig ausgebildet sind.

12. Verwendung nach einem der vorgehenden Ansprüche, **dadurch gekennzeichnet, dass** die Elektrode (405) der Vorrichtung (100..103) in ihrem Randbereich in Richtung des zu beschichtenden Pressblechs (2) gebogen ist.

13. Verfahren zur Plasmabeschichtung eines Pressblechs (2), **gekennzeichnet durch** die Schritte:
a) Anordnen eines zu beschichtenden Pressblechs (2) in einer Vakuumkammer (3) gegenüber einer in der Vakuumkammer (3) angeordneten, segmentierten Elektrode (400..409) und im Wesentlichen parallel ausgerichtet zu derselben,
b) Aktivierung wenigstens einer, einem Elektrodensegment (500..512) der Elektrode (400..409) zugeordneten Energiequelle (700..706) und
c) Einleiten eines Gases, welches eine plasmaunterstützte chemische Gasphasenabscheidung auf dem Pressblech-Rohling (2) bewirkt.

14. Verfahren nach Anspruch 13, **dadurch gekennzeichnet, dass** je eine Energiequelle (701..706) pro Elektrodensegment (500..512) aktiviert und unabhängig von den übrigen Energiequellen (701..706) gesteuert/geregelt wird.

15. Verfahren nach Anspruch 13 **dadurch gekennzeichnet, dass** eine Energiequelle (701, 702) abwechselnd auf je ein Elektrodensegment (508) einer Gruppe (1301, 1302) von Elektrodensegmenten (508) und die Anschlüsse (6) der übrigen Elektrodensegmente (508) dieser Gruppe (1301. 1302) in einen vom erstgenannten Elektrodensegment (508) isolierten Offen-Zustand geschaltet werden.

16. Verfahren nach Anspruch 15, **dadurch gekennzeichnet, dass** die Auswahl des Elektrodensegments (508), welcher der aktivierten Energiequelle (701, 702) zugeordnet ist, zufällig erfolgt.

17. Verfahren nach Anspruch 15, **dadurch gekennzeichnet, dass** nach Art der weißen Felder eines Schachbretts angeordnete Elektrodensegmente (509) und nach Art der schwarzen Felder eines Schachbretts angeordnete Elektrodensegmente (509) abwechselnd mit elektrischer Energie versorgt werden.

18. Verfahren nach einem der Ansprüche 13 bis 17, **dadurch gekennzeichnet, dass** die Spannung zwischen einem Elektrodensegment (511) und dem zu beschichtenden Pressblech (2) gemessen wird und die Energieversorgung abgeregelt oder abgeschaltet wird, wenn ein Einbruch der genannten Spannung festgestellt wird.

19. Verfahren nach einem der Ansprüche 13 bis 18, **dadurch gekennzeichnet, dass** am Rand der Elektrode (409) gelegene Elektrodensegmente (512) auf ein höheres Potential gelegt werden, als innenliegende Elektrodensegmente (512).

20. Verfahren nach einem der Ansprüche 13 bis 19, **dadurch gekennzeichnet, dass** am Rand der Elektrode (409) gelegene Elektrodensegmente (512) auf eine höhere Stromstärke eingestellt/geregelt werden, als innenliegende Elektrodensegmente (512).

21. Verfahren zur Herstellung ein- oder mehrschichtiger plattenförmiger Werkstoffe, insbesondere von Kunststoffen, Holzwerkstoffen und Laminaten mit und ohne Overlaypapieren, **dadurch gekennzeichnet, dass** dafür ein Pressblech (2) eingesetzt wird, das durch die Schritte
a) Anordnen eines zu beschichtenden Pressblechs (2) in einer Vakuumkammer (3) gegenüber einer in der Vakuumkammer (3) angeordneten, segmentierten Elektrode (400..409) und im Wesentlichen parallel ausgerichtet zu derselben,
b) Aktivierung wenigstens einer, einem Elektrodensegment (500..512) der Elektrode (400..409) zugeordneten Energiequelle (700..706) und
c) Einleiten eines Gases, welches eine plasmaunterstützte chemische Gasphasenabscheidung auf dem Pressblech (2) bewirkt,
hergestellt ist.

22. Verfahren nach Anspruch 21, **dadurch gekennzeichnet, dass** die Fläche der hergestellten Platten größer oder gleich 1 m² ist.

23. Verfahren nach Anspruch 21 oder 22, **dadurch gekennzeichnet, dass** der plattenförmige Werkstoff Partikel mit einer Vickershärte zwischen 1000 und 1800 beinhaltet, insbesondere im Bereich seiner dem Pressblech (2) zugewandten Oberfläche.

24. Verfahren nach Anspruch 21 oder 22, **dadurch gekennzeichnet, dass** der plattenförmige Werkstoff Korund beziehungsweise Aluminiumoxid Al₂O₃ beinhaltet, insbesondere im Bereich seiner dem Pressblech (2) zugewandten Oberfläche.

## Claims

1. Use of an apparatus (100..103) for the plasma coating of a press platen (2) wherein the apparatus comprises a vacuum chamber (3) and an electrode (400..409) arranged therein which is, during operation, aligned to be substantially parallel with said press platen (2) and opposite its face to be coated, wherein the electrode (400..409) is segmented and each of the electrode segments (500..512) has a dedicated connection (6) for an electrical energy source (700..702).

2. The use according to claim 1, **characterized in that** the individual electrode segments (501, 504, 505) of the apparatus (100..103) are insulated from one another.

3. The use according to claim 1, **characterized in that** the individual electrode segments (502, 503) of the apparatus (100..103) are connected to one another via narrow webs (9) or defined ohmic resistances.

4. The use according to one of claims 1 to 3, **characterized in that** the individual electrode segments (510) of the apparatus (100..103) are connected to at least one energy source (700) via narrow webs or defined ohmic resistances.

5. The use according to one of claims 1 to 4, **characterized in that** the apparatus (100..103) comprises several energy sources (701, 702) which can be open-loop/closed-loop controlled independently of one another and which are connected to the electrode segments (500..512) via said connections (6).

6. The use according to claim 5, **characterized in that** one electrode segment (510) of the apparatus (100..103) is connected to one respective energy source (701..706), which can be open-loop/closed-loop controlled independently of the remaining energy sources (701..706).

7. The use according to claim 5, **characterized in that** the apparatus (100..103) comprises a control unit (1101) which is configured so as to alternately switch one energy source (701, 702) to one respective electrode segment (508) of a group (1301, 1302) of electrode segments (508) and to switch the connections (6) of the remaining electrode segments (508) of this group (1301, 1302) to an open-state insulated from the firstly-mentioned electrode segment (508).

8. The use according to one of the preceding claims, **characterized in that** the area of an electrode segment (500..512) of the apparatus (100..103) is less than or equal to 1 m².

9. The use according to one of the preceding claims, **characterized in that** the energy sources (700..706) of the apparatus (100..103) are configured as current sources.

10. The use according to claim 9, **characterized in that** the maximum current per electrode segment (500..512) is less than or equal to 150 A.

11. The use according to one of the preceding claims, **characterized in that** the electrode segments (503) of the apparatus (100..103) are embodied to be grid-like.

12. The use according to one of the preceding claims, **characterized in that** the electrode (405) of the apparatus (100..103) in its edge region is bent in the direction of the press platen (2) to be coated.

13. Method for plasma coating of a press platen (2) **characterized by** the steps:
a) arranging a press platen (2) to be coated in a vacuum chamber (3) opposite a segmented electrode (400..409) arranged in the vacuum chamber (3) and aligned to be substantially parallel with the electrode (400..409),
b) activating at least one energy source (700..706) that is assigned to an electrode segment (500..512) of the electrode (400..409) and
c) introducing a gas which causes a plasma-enhanced chemical vapour deposition on the press platen blank (2).

14. Method according to claim 13, **characterized in that** one energy source (701..706) is activated per each electrode segment (500..512) and open-loop/closed-loop controlled independently of the remaining energy sources (701..706).

15. Method according to claim 13, **characterized in that** one energy source (701, 702) is alternately switched to one respective electrode segment (508) of a group (1301, 1302) of electrode segments (508) and the connections (6) of the rest of the electrode segments (508) of this group (1301, 1302) is switched to an open-state insulated from the firstly mentioned electrode segment (508).

16. Method according to claim 15, **characterized in that** the electrode segment (508) which is assigned to the activated energy source (701..702) is a result of a random selection.

17. Method according to claim 15, **characterized in that** the electrode segments (509) arranged so as to correspond to the white squares of a chessboard and electrode segments arranged (509) so as to correspond to the black squares of a chessboard are supplied with electrical energy in alternation.

18. Method according to one of claims 13 to 17, **characterized in that** the voltage between an electrode segment (511) and the press platen (2) to be coated is measured and the energy supply is limited or switched off in the event that a drop of said voltage is detected.

19. Method according to one of claims 13 to 18, **characterized in that** electrode segments (512) located at the edge of the electrode (409) are set at a higher potential than inner electrode segments (512).

20. Method according to one of claims 13 to 19, **characterized in that** electrode segments (512) located at the edge of the electrode (409) are set at/regulated to a higher current intensity than inner electrode segments (512).

21. Method for the manufacture of single-layer or multi-layer board type materials, in particular of plastic materials, wood materials and laminates with and without overlay papers, **characterized in that** a press platen (2) manufactured by the steps
a) arranging a press platen (2) to be coated in a vacuum chamber (3) opposite a segmented electrode (400..409) arranged in the vacuum chamber (3) and aligned to be substantially parallel with the electrode (400..409),
b) activating at least one energy source (700..706) that is assigned to an electrode segment (500..512) of the electrode (400..409) and
c) introducing a gas which causes a plasma-enhanced chemical vapour deposition on the press platen blank (2), is used for this purpose.

22. Method according to claim 21, **characterized in that** the area of the manufactured plates is larger than or equal to 1 m².

23. Method according to claim 21 or 22, **characterized in that** the board-type material contains particles having a Vickers hardness of between 1000 and 1800, in particular in the region of its surface facing the press platen (2).

24. Method according to claim 21 or 22, **characterized in that** the board-type material contains corundum or aluminium oxide Al₂O_{3,} in particular in the region of its surface facing the press platen (2).

## Revendications

1. Utilisation d'un dispositif (100 ... 103) pour le revêtement au plasma d'une tôle emboutie (2), le dispositif comprenant une chambre à vide (3) et une électrode (400 ... 409) disposée là-dedans qui, en fonctionnement, est orientée sensiblement parallèlement à la tôle emboutie (2) et en regard de la face à revêtir, l'électrode (400 ... 409) étant segmentée et chacun des segments d'électrode (500 ... 512) comportant sa propre borne (6) pour une source d'énergie électrique (700 ... 702).

2. Utilisation selon la revendication 1, **caractérisé en ce que** les différents segments d'électrode (501, 504, 505) du dispositif (100 ... 103) sont isolés les uns des autres.

3. Utilisation selon la revendication 1, **caractérisé en ce que** les différents segments d'électrode (502, 503) du dispositif (100 ... 103) sont connectées les uns aux autres par des barres minces (9) ou des résistances ohmiques définis.

4. Utilisation selon l'une des revendications 1 à 3, **caractérisé en ce que** les différents segments d'électrode (510) du dispositif (100 ... 103) sont connectées à au moins une source d'énergie (700) par des barres minces ou des résistances ohmiques définis.

5. Utilisation selon l'une quelconque des revendications 1 à 4, **caractérisé en ce que** le dispositif (100 ... 103) comprend plusieurs sources d'énergie (701, 702) adaptées pour être commandées/réglées indépendamment les unes des autres, qui sont connectées aux segments d'électrode (500 ... 512) par lesdites bornes (6).

6. Utilisation selon la revendication 5, **caractérisé en ce qu'**un segment d'électrode (510) du dispositif (100 ... 103) est connecté individuellement avec une source d'énergie (701 ... 706) qui est adaptée pour être commandée/réglée indépendamment des autres sources d'énergie (701 ... 706).

7. Utilisation selon la revendication 5, **caractérisé en ce que** le dispositif (100 ... 103) comprend une commande (1101) qui est adaptée pour commuter une source d'énergie (701, 702) en alternance sur un segment d'électrode (508) d'un groupe (1301, 1302) de segments d'électrodes (508) et les bornes (6) des autres segments d'électrode (508) de ce groupe (1301, 1302) dans un état d'ouverture isolé du segment d'électrode (508) désigné en premier.

8. Utilisation selon l'une quelconque des revendications précédentes, **caractérisé en ce que** la surface d'un segment d'électrode (500 ... 512) du dispositif (100 ... 103) est inférieure à 1 m².

9. Utilisation selon l'une quelconque des revendications précédentes, **caractérisé en ce que** les sources d'énergie (700 ... 706) du dispositif (100 ... 103) sont conformées comme sources de courant.

10. Utilisation selon la revendication 9, **caractérisé en ce que** le courant maximal par segment d'électrode (500 ... 512) est inférieur ou égal à 150 A.

11. Utilisation selon l'une quelconque des revendications précédentes, **caractérisé en ce que** les segments d'électrode (503) du dispositif (100 ... 103) sont conformés à la forme d'une grille.

12. Utilisation selon l'une quelconque des revendications précédentes, **caractérisé en ce que** l'électrode (405) du dispositif (100 ... 103) est courbée dans sa zone de bord en direction de la tôle emboutie (2) à revêtir.

13. Procédé pour le revêtement au plasma d'une tôle emboutie (2) **caractérisé par** les étapes :
a) disposer une tôle emboutie (2) à revêtir dans une chambre à vide (3) en regard d'une électrode segmentée (400 ... 409) disposée dans la chambre à vide (3), et orientée sensiblement parallèlement à l'électrode,
b) activer au moins une source d'énergie (700 ... 706) associée à un segment d'électrode (500 ... 512) de l'électrode (400 ... 409), et
c) introduire un gaz qui cause un dépôt en phase vapeur chimique à support de plasma, sur l'ébauche de tôle emboutie (2).

14. Procédé selon la revendication 13, **caractérisé en ce qu'**une source d'énergie (701 ... 706) par segment d'électrode (500 ... 512) est activée et est commandée/réglée indépendamment des autres sources d'énergie (701 ... 706).

15. Procédé selon la revendication 13, **caractérisé en ce qu'**une source d'énergie (701, 702) est commutée en alternance sur un segment d'électrode (508) d'un groupe (1301, 1302) de segments d'électrodes (508) et les bornes (6) des autres segments d'électrode (508) de ce groupe (1301, 1302) dans un état d'ouverture isolé du segment d'électrode (508) désigné en premier.

16. Procédé selon la revendication 15, **caractérisé en ce que** la sélection du segment d'électrode (508) qui est associé à la source d'énergie (701, 702) activée est aléatoire.

17. Procédé selon la revendication 15, **caractérisé en ce que** des segments d'électrode (509) disposés à la façon des champs blancs d'un échiquier et des segments d'électrode (509) disposés à la façon des champs noirs d'un échiquier sont alimentés en énergie électrique de manière alternante.

18. Procédé selon l'une quelconque des revendications 13 à 17, **caractérisé en ce que** la tension entre un segment d'électrode (511) et la tôle emboutie (2) à revêtir est mesurée et que l'alimentation en énergie est réglée en baisse ou est arrêtée lorsqu'une chute de ladite tension est constatée.

19. Procédé selon l'une quelconque des revendications 13 à 18, **caractérisé en ce que** des segments d'électrode (512) situés au bord de l'électrode (409) sont mis à un potentiel plus élevé que des segments d'électrode (512) situés à l'intérieur.

20. Procédé selon l'une quelconque des revendications 13 à 19, **caractérisé en ce que** des segments d'électrode (512) situés au bord de l'électrode (409) sont ajustés/réglés à un courant plus fort que des segments d'électrode (512) situés à l'intérieur.

21. Procédé pour la fabrication de matériau en forme de plaques à une ou plusieurs couches, notamment de matières synthétiques, de matériaux en bois ou de stratifiés avec ou sans papiers overlay, **caractérisé en ce que** l'on y utilise une tôle emboutie (2) qui est fabriquée par les étapes
a) disposer une tôle emboutie (2) à revêtir dans une chambre à vide (3) en regard d'une électrode segmentée (400 ... 409) disposée dans la chambre à vide (3), et orientée sensiblement parallèlement à l'électrode,
b) activer au moins une source d'énergie (700 ... 706) associée à un segment d'électrode (500 ... 512) de l'électrode (400 ... 409), et
c) introduire un gaz qui cause un dépôt en phase vapeur chimique à support de plasma, sur la tôle emboutie (2).

22. Procédé selon la revendication 21, **caractérisé en ce que** la surface des plaques fabriquées est supérieure ou égale à 1 m².

23. Procédé selon la revendication 21 ou 22, **caractérisé en ce que** le matériau en forme de plaques comprend des particules ayant une dureté Vickers entre 1000 et 1800, notamment dans la zone de sa surface orientée vers la tôle emboutie (2).

24. Procédé selon la revendication 21 ou 22, **caractérisé en ce que** le matériau en forme de plaques comprend du corindon ou alumine Al₂O₃, notamment dans la zone de sa surface orientée vers la tôle emboutie (2).
